# EUROPEAN PATENT APPLICATION

(11) **EP 0 527 015 A2**
(43) Date of publication of application: **10.02.1993**
(21) Application number: 92306910.8
(22) Date of filing: 29.07.1992
(51) Int. Cl.: H03K 19/00, G11C 7/02

(54) **Low power signaling using output impedance delay**

(30) Priority: 06.08.1991 US 740695
(71) Applicant: AT&T Corp., New York, NY 10013-2412 (US)
(72) Inventor: McLellan, Hubert Rae, Jr., Califon, New Jersey 07830 (US)
(74) Representative: Buckley, Christopher Simon Thirsk

(57) **Abstract**

A method and apparatus for reducing the power consumed by computers in signaling between integrated circuits (101). Circuitry (115) within an integrated circuit (101) assures that the integrated circuit only outputs valid data (111) thereby conserving the energy that would be otherwise wasted if the integrated circuit were required to output spurious data. The invention is particularly useful in semiconductor memories and other devices which utilize tri-state buffers (109).

## Description

### Background of the Invention

### Field of the Invention

This invention relates to low power electronic signaling in general and in particular, to a method and apparatus for reducing the power consumption associated with transmitting data between integrated circuits.

### Description of the Prior Art

An integrated circuit ("IC") consumes a substantial amount of power when it transmits signals to other ICs via off-chip conductors. While there is some power consumption associated with *maintaining* a voltage level on a conductor (e.g., keeping the voltage on a wire at either 0 volts or 5 volts), additional power is consumed in the *transition* from one voltage to another (e.g., changing the voltage on a wire from 5 volts to 0 volts or vice versa).

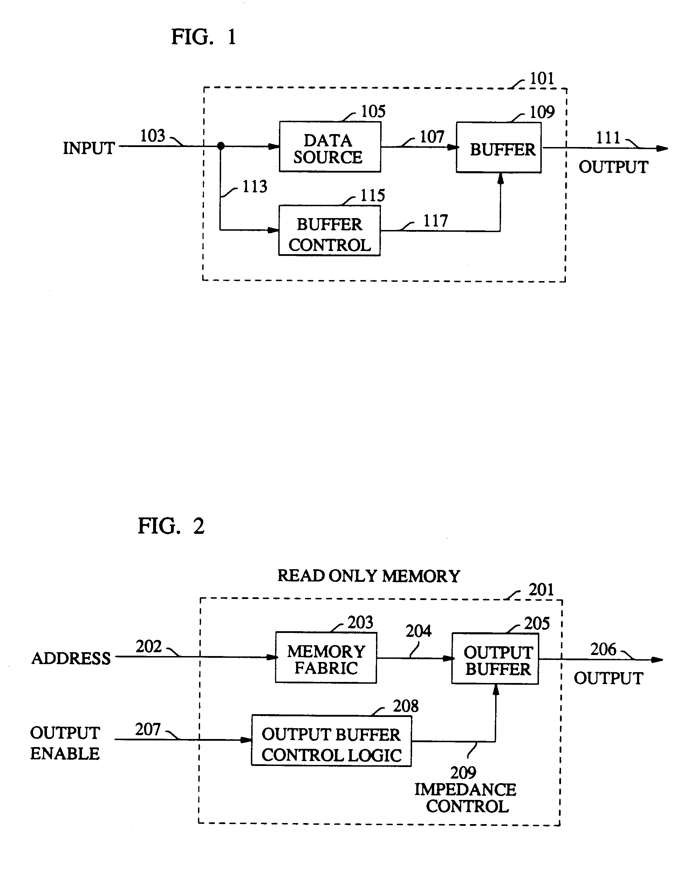

As shown in Fig. 1, integrated circuits 101 often employ buffers 109 with tri-state logic to regulate the flow of data 107 to their outputs 111. Such buffers can assume three states: a high impedance state, a low impedance state with a low signal on the output and a low impedance state with a high signal on the output. When the IC is not transmitting, the output buffer is put in the high impedance state. In this state the output buffer's output appears to be an open-circuit to the conductor. When the IC is transmitting the output buffer is set to whichever of the two low impedance states correspond to the signal that is to be put on the output. For example, if an IC wishes to transmit a boolean "1" on a particular off-chip conductor the respective output buffer must enter the low impedance state and put 5 volts on the conductor.

When an integrated circuit is to begin transmitting it changes the state of the output buffer 109 from the high impedance state to one of the low impedance states. It is important to note that the IC does this even *before* the data intended to be output is available for output. While this design philosophy assures that the IC is as fast as possible it has the drawback that the IC outputs spurious data until the valid data becomes available. The ultimate consequence is that when the data to be output does become available, the IC is forced to expend energy to change the output from transmitting spurious data to transmitting valid data. In a binary digital computer this causes, statistically, one-half of the individual off-chip signals to undergo an energy wasting voltage transition. These voltage transitions also generate electromagnetic interference which can cause problems for nearby circuitry.

### Summary of the Invention

An object of the invention is to improve the energy efficiency of an integrated circuit by reducing the number of off-chip voltage transitions that the integrated circuit generates.

Another object of the invention is to reduce the number of voltage transitions without hindering the computational capability of the computer encompassing the integrated circuit.

Yet another object of the invention is to reduce the amount of electromagnetic interference generated by an integrated circuit.

The invention is a buffer control which puts the output buffer into the low impedance state only when valid data is available for output. Another aspect of the invention is that the output buffer should go into the high impedance state *immediately* upon being directed to so by the output enable.

### Brief Description of the Drawing

FIG. 1 is a block diagram of an apparatus which reduces the number of voltage transitions generated by an integrated circuit.

FIG. 2 is a block diagram of a read-only memory (ROM) employing a preferred embodiment of the invention.

FIG. 3 is a timing diagram of the operation of the apparatus in Fig. 2.

### Detailed Description

### I. Theory of Implementation

As shown in Fig. 1, circuitry (e.g., buffer control 115) is added to the integrated circuit 101 which delays putting the output buffer 109 into the low impedance state until valid data becomes available and not necessarily when directed to do so by the output enable 113. The circuitry required to fabricate the buffer control 115 is easily designed by one having ordinary skill in the art.

Additionally, the output buffer 109 should go into the high impedance state *immediately* upon being commanded to do so by the output enable 113. While the buffer control 115 delays changing the output buffer from the high impedance state to one of the low impedance states, in most embodiments no such delay is permissible in the transition to the high impedance state. While the need for this asymmetry is not intuitive it is necessary to insure that the integrated circuit 101 does not cause bus contention on the output 111. Bus contention results when more than one device, e.g., IC 101, attempts to simultaneously put signals onto the same output 111.

### II. Preferred Embodiment

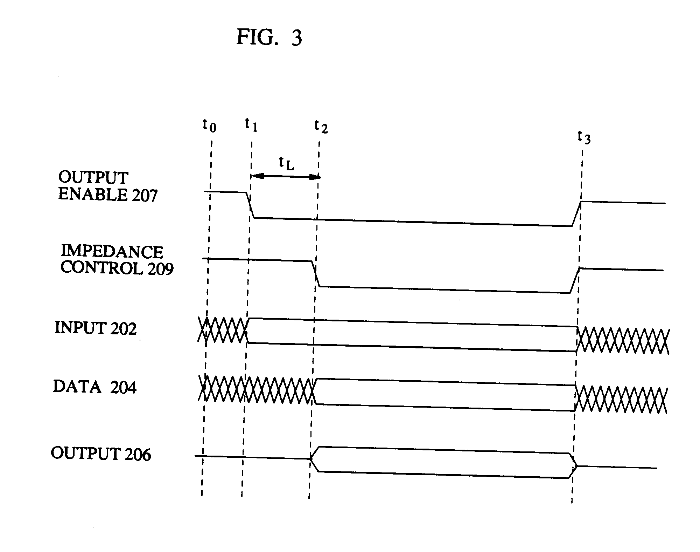

A preferred embodiment is the read only memory (ROM) shown in Fig. 2. In other preferred embodiments, that are obvious variations of the one disclosed here, the memory fabric 203 contains a static random access memory (RAM), a dynamic RAM, a microprocessor or other logic. The ROM is fabricated on a single integrated circuit 201. The memory fabric 203 provides the data 204 to be put on the output 206 of the integrated circuit 201. The memory fabric 203 accepts an address 202 from a source that is external to the IC 201.

An output buffer 205 is used to regulate the flow of data 204 from the memory fabric 203 to the output 206. The output buffer 205 is composed of tri-state logic and is controlled by an impedance control 209. When the impedance control 209 is asserted the output buffer 205 immediately puts the data 204 onto the output 206. When the impedance control 209 is retracted the output buffer 205 immediately enters the high impedance state such that the integrated circuit 201 appears to be an open circuit to the output 206.

The impedance control 209 is generated by the output buffer control logic 208. The output buffer control logic 208 is in turn actuated by an externally generated signal called the output enable 207. In another preferred embodiment the output enable 207 is generated by logic contained within the integrated circuit 201. When the output enable 207 is asserted the output buffer control logic 208 waits, for a period of time defined as *t*_{*L*}, to assert the impedance control 209. This latency, *t*_{*L*}, is shown in Fig. 3 and is discussed *infra*. When output enable 207 is retracted the output buffer control logic 208 immediately retracts the impedance control 209.

Fig. 3 shows the temporal relationship of the output 206 to the input 202, the data 204, the output enable 207 and the impedance control 209. Initially, at time *t*₀, the output enable 207 and the impedance control 209 are retracted (high), the input 202 and the data 204 are undefined (as represented by the cross-hatching) and the output 206 is in the high impedance state (as represented by the horizontal line that is neither high nor low).

At time *t*₁, the output cycle begins. This occurs, by definition, when the output enable 207 is asserted (driven low) and should coincide with the point in time when the input 202 becomes defined (as represented by the transition from cross-hatching to the pair of horizontal lines). At time *t*₁ the memory fabric 203 begins to formulate the data 204 based upon the input 202. By definition the data 204 becomes valid at time *t*₂ (as represented by the transition from cross-hatching to the pair of horizontal lines). The period between *t*₁ and *t*₂ is defined as the latency of the memory fabric *t*_{*L*}. The latency of a memory fabric is easily determined by one having ordinary skill in the art.

Also at *t*₂ (or *t*_{*L*} time after *t*₁) the output buffer control logic 208 asserts (drives low) the impedance control 209. This immediately causes the output buffer 205 to change to the low impedance state and to put the data 204 onto the output 206 (as represented by the transition from the single horizontal line that is neither high nor low the pair of horizontal lines). Note that at no time has spurious data been put onto the output 206 (as would be represented by cross-hatching).

Subsequently, and by definition at time *t*₃, the output enable 207 is retracted (driven high). Upon sensing this, the output buffer control logic 208 immediately retracts (drives high) the impedance control 209. This in turn immediately causes the output buffer 205 to re-enter the high impedance state (as represented by the single horizontal line that is neither high nor low). Also at time *t*₃ the input 202 and the data 204 become undefined (as represented by the transition to cross-hatching).

## Claims

1. Apparatus for outputting only valid data comprising a buffer (109) for receiving data (107) and outputting data (111) in response to the assertion of a buffer output signal (117), and buffer control means (115) for determining when the received data (107) is valid and thereupon asserting the buffer output signal (117).

2. Apparatus as claimed in claim 1 comprising a data source (105) for generating the data (107) that is sent to the buffer (109) in response to an input (103).

3. Apparatus as claimed in claim 2 wherein the buffer (109), the data source (105) and the buffer control means (115) are fabricated on a single integrated circuit (101).

4. Apparatus as claimed in claim 2 or 3 wherein the buffer control means (115) determines when the received data is valid in response to the input (103).

5. Apparatus as claimed in claim 2,3 or 4 wherein the input (103) is generated by a source that is within the integrated circuit (101).

6. Apparatus as claimed in claim 2,3 or 4 wherein the input (103) is generated by a source that is without the integrated circuit (101).

7. A method for outputting only valid data comprising the steps of receiving data (107) in a buffer (109), determining, in buffer control means (115), when the data (107) is valid, and outputting the data (107) upon determination that the data (107) is valid.

8. A method as claimed in claim 7, or apparatus as claimed in any one of claims 1 to 6, wherein the buffer control means (115) delays assertion of the buffer output signal (117) until the received data 107 is valid.

9. A method as claimed in claim 7 or 8, or apparatus as claimed in any one of claims 1 to 6, wherein when the buffer control means (115) is directed by an output enable signal (113) to retract the buffer output signal (117), the buffer control means (115) immediately retracts the buffer output signal (117).

10. A method as claimed in claim 7,8 or 9 comprising the step of inputting input (103) from which the data (107) is derived.

11. A method as claimed in claim 7,8,9 or 10 wherein in the step of outputting the buffer (109) is responsive to the buffer output signal (117).

12. A memory comprising a tri-state output buffer (205) for receiving data (204) which puts the data (204) on the output (206) in response to the assertion of an impedance control signal (209) and which puts the output buffer (205) into a high impedance state in response to the retraction of the impedance control signal (209), a memory fabric (203) responsive to an address (202) for generating the data (204), and output buffer control logic (208) responsive to an output enable signal (207) for generating the impedance control signal (209) such that when the output enable signal (207) is asserted the output buffer control logic (208) delays assertion of the impedance control (209) until the data (204) is valid, and when the output enable signal (207) is retracted the impedance control signal (209) is immediately retracted.

13. A memory as claimed in claim 12 wherein the memory is a random access memory.

14. A memory as claimed in claim 12 wherein the memory is a dynamic random access memory.

15. A memory of claim 12 wherein the memory is a static random access memory.

16. A memory of claim 12 wherein: the memory is a read only memory.

17. A memory comprising a tri-state output buffer (205) for receiving data (204) which puts the data (204) on the output (206) in response to the assertion of an impedance control signal (209) and which puts the output buffer (205) into a high impedance state in response to the retraction of the impedance control signal (209), a memory fabric (203) responsive to an address (202) for generating the data (204), and output buffer control logic (208) responsive to an output enable signal (207) for generating the impedance control signal (209) such that when the output enable signal (207) is asserted the output buffer control logic (208) delays assertion of the impedance control (209) until the data (204) is valid.
